# EUROPÄISCHE PATENTANMELDUNG

(11) **EP 0 608 682 A1**
(43) Veröffentlichungstag der Anmeldung: **03.08.1994**
(21) Anmeldenummer: 94100071.3
(22) Anmeldetag: 04.01.1994
(51) Int. Cl.: H03M 11/08, G06F 3/023

(54) **Verfahren und Anordnung zur Generierung von einzelnen Zeichen bezeichnenden Informationen**

(30) Priorität: 29.01.1993 DE 4302528
(71) Anmelder: SIEMENS AKTIENGESELLSCHAFT, D-80333 München (DE)
(72) Erfinder: Lukas, Günter, A-1150 Wien (AT); Ramberger, Friedrich, A-2332 Hennersdorf (AT); Spahl, Siegfried, D-82178 Puchheim (AT)

(57) **Zusammenfassung**

In einer Tastatur sind einzelnen Tasten neben Ziffern auch Buchstabengruppen zugeordnet. Zur Auswahl eines Buchstabens aus einer Gruppe sind zwei Tastenbetätigungen erforderlich; die Betätigung der Taste, die den betreffenden Buchstaben enthält, sowie eine Taste, die die Stellung des Buchstabens in einer Buchstabengruppe bezeichnet. Vorteil: Keine gesonderte Taste (Umschalttaste) für die Auswahl des gewünschten Zeichens und keine Endekennungstaste erforderlich; keine Betätigung von Tasten innerhalb einer vorgegebenen Zeit erforderlich.

## Beschreibung

Die Erfindung betrifft ein Verfahren und eine Anordnung nach dem Oberbegriff des Patentanspruchs 1 bzw. nach Patentanspruch 2.

Es sind bereits Tastaturen mit Tasten bekannt, denen mehr als ein Zeichen bzw. mehr als eine Funktion zugeordnet sind. Tasten, die der Eingabe von Textinformationen dienen, sind beispielsweise Buchstaben in Klein- oder Großschreibweise zugeordnet, wobei die entsprechende Tastatur eine Umschaltetaste enthält, mit der der Großschreibmodus aktiviert wird.

Ferner sind Fernmeldeendgeräte mit Tasten bekannt, denen neben jeweils einer Ziffer auch eine Buchstabengruppe, beispielsweise ABC,DEF,... zugeordnet ist. Derartige Tastaturen enthalten eine weitere Umschalttaste, die der Auswahl eines Buchstabens aus der Buchstabengruppe dient.

Bekannt sind auch Tastaturen mit derartigen Tasten, wobei zur Generierung eines von mehreren Zeichen dieselbe Taste innerhalb einer vorgebbaren Zeit ein- oder mehrmals zu betätigen ist. Eine derartige Betriebsweise erweist sich jedoch als fehleranfällig, insbesondere wenn dieselbe Taste innerhalb der vorgegebenen Zeit mehrmals, beispielsweise viermal zu betätigen ist. Ein weiterer Nachteil dieser Betriebsweise besteht darin, daß die Betätigung einer Taste zur Bildung eines weiteren Zeichens erst nach Ablauf der Zeit ("timeout") erfolgen kann, die für die Bildung des vorangehenden Zeichens vorgegeben ist.

Ferner sind auch Verfahren bekannt, die anstelle eines "timeout" die Betätigung einer Endekennungstaste erfordern. Damit ist einerseits die Tastatur um eine weitere Taste zu ergänzen und andererseits ist die weitere Tastenbetätigung erforderlich, die zusätzliche Zeit erfordert und zu Fehlern an der Bedienung fuhren kann.

Ausgehend von diesem Stand der Technik liegt der Erfindung das technische Problem zugrunde, ein Verfahren der eingangs genannten Art anzugeben, das für Benutzer durch entsprechende Tastenbetätigung in einfacher Weise auslösbar ist.

Die Lösung dieses Problems erfolgt mit den Merkmalen des Patentanspruchs 1. Als wesentlich für die Erfindung ist anzusehen, daß zur Bildung beliebiger Zeichen aus dem Zeichenvorrat in jedem Fall genau dieselbe Anzahl von Tastenbetätigungen vorzunehmen sind. Es sind dies jeweils nur 2 Tastenbetätigungen. Nach der zweiten Tastenbetätigung zur Bildung eines ersten Zeichens kann unmittelbar die Bildung eines weiteren Zeichens durch eine erste Tastenbetätigung eingeleitet werden. Es ist also keine Zeit abzuwarten, bis die Generierung eines weiteren Zeichens eingeleitet werden kann. Außerdem erübrigt es sich, eine Endekennungstaste zu betätigen.

Ein weiterer Vorteil der Erfindung besteht darin, daß eine Sondertaste für die Auswahl von Zeichen aus einer jeweils einer Taste zugeordneten Zeichengruppe nicht erforderlich ist.

Vorteilhafte Ausführungsformen der Erfindung sind dadurch gekennzeichnet, daß die Tasten in Zeilen und/oder Spalten angeordnet sind und daß die beiden Tasten, die zur Bildung jeweils einer Zeicheninformation zu betätigen sind, in derselben Zeile oder in derselben Spalte angeordnet sind. Damit sind also die zur Bildung jeweils eines Zeichens zu bedienenden Tasten in einem relativ kleinen Abstand zueinander angeordnet, so daß die aufeinanderfolgenden Tastenbetätigungen durch ergonomisch günstige, kurze Wege erleichtert werden und eine zeitlich kurz aufeinanderfolgende Betätigung der zweiten Taste ermöglicht wird.

Die Erfindung wird nun anhand der Figuren beschrieben.

Es zeigt
- Fig. 1: ein Flußdiagramm des erfindungsgemäßen Verfahrens, und
- Fig. 2: eine Anordnung zur Durchfuhrung des Verfahrens nach Anspruch 1.

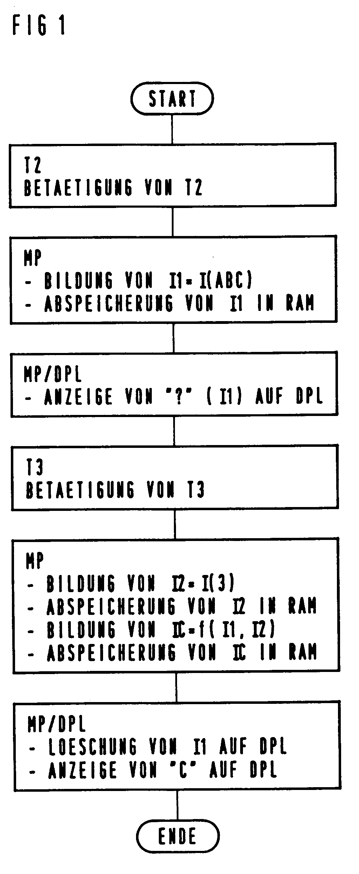

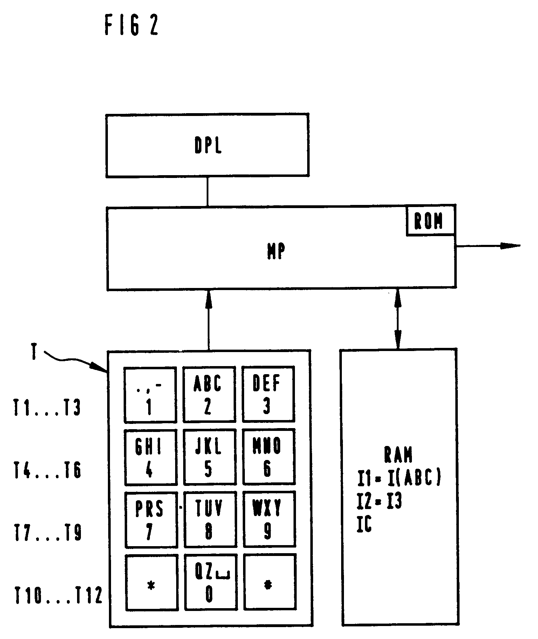

Bei dem in Fig. 1 dargestellten Flußdiagramm wird davon ausgegangen, daß eine Information generiert wird, die den Buchstaben "c" bezeichnet. Dieses Zeichen "c" ist einer ersten Taste zugeordnet, der neben einer Ziffer die Buchstabenkombination ABC zugeordnet ist (Fig. 2). Die in Fig. 2 dargestellte Tastatur eines Telefons ist zeilen- und spaltenweise angeordnet; sie umfaßt 12 Tasten, die in 4 Zeilen und 3 Spalten angeordnet sind.

Der Tastatur ist eine Mikroprozessorsteuerung MP mit einem Steuerungsprogramm zugeordnet. Dieses ist in der folgenden Weise ausgestaltet:
Ausgelöst durch die Betätigung der Taste, der das gewünschte Zeichen "C" zugeordnet ist (T2) bildet die Steuerung MP eine erste Information I1, die die dieser Taste T2 zugeordnete Zeichenkombination ABC bezeichnet. Die Information I1 wird in dem Speicher RAM abgelegt. Zusätzlich kann die Steuerung MP eine Anzeigerichtung DPL ansteuern, im vorliegenden Fall ist dies das Display eines Telefons, und beispielsweise eine Information anzeigen, die eine beliebige erste Information bezeichnet. Beispielsweise wird das Zeichen "?" angezeigt, das die Bedienperson zugleich auf eine zweite erforderliche Tastenbetätigung hinweist. Die weitere Behandlung des Zeichens "?" wird unten beschrieben.

Im vorliegenden Beispiel wird zur Bildung des Zeichens "C", das in der Buchstabengruppe ABC der Taste T2 an dritter Stelle angeordnet ist, die Taste T3 betätigt. Dies ist die dritte Taste derjenigen Zeile, in der die erste Taste angeordnet ist.

Ist das Zeichens "U" zu bilden, wird zunächst die erste Taste T8 betätigt, der die Buchstabenkombination TUV zugeordnet ist, und im Anschluß daran wiederum dieselbe (zweite = erste) Taste T8, das heißt die zweite Taste in der betreffenden Tastenteile, da "U" an zweiter Stelle innerhalb der Zeichenkombination TUV angeordnet ist.

Die Steuerung MP bildet nun nach Betätigung der zweiten Taste (z.B. T3) eine zweite Information I2, die bei dem zunächst dargestellten Beispiel für das Zeichen "C" die dritte Stelle "3" innerhalb der Zeichenkombination ABC bezeichnet. Die Steuerung MP legt diese zweite Information I2 im Speicher RAM ab und generiert aus der ersten und zweiten Information I1,I2 eine das gewünschte Zeichen "C" bezeichnende Information IC. Diese Information wird beispielsweise an die Steuerung eines Fernmelde-Endgeräts an eine Vermittlungsanlage oder eine sonstige Einrichtung übermittelt, die die generierte Zeicheninformation weiter verarbeitet.

Die in Fig. 2 dargestellte Anordnung zur Durchführung des erfindungsgemäßen Verfahrens enthält als wesentliche Elemente die Mikroprozessorsteuerung MP, die Tastatur T sowie einen Speicher RAM zur Aufnahme gebildeter Informationen. Die Steuerung MP ist ferner mit einer Anzeigeeinrichtung DPL verbunden, auf der die Zeicheninformationen und gegebenenfalls Informationen I1 darstellbar sind, die für die Bildung der gewünschten Zeicheninformationen verwendet werden. Die Tastatur T besteht aus 12 Tasten T1...T12, die in 4 Zeilen mit jeweils 3 Tasten aufgeteilt ist. Bei dem in Fig. 2 dargestellten Beispiel sind also 3 Tastenspalten vorgesehen. Die Zahl (3) der Tasten pro Zeile entspricht der Anzahl der Zeichen, die jeweils eine Zeichengruppe (ABC,DEF) bilden. Neben diesen Tasten, die auf den jeweiligen Tasten T1...T12 im oberen Bereich dargestellt sind, sind diesen Tasten jeweils noch eine Ziffer 1...0 bzw. die Zeichen "*" und "#" zugeordnet. Die Generierung von Zeichen Zeicheninformationen, die Ziffern bezeichnen, wird beispielsweise durch Betätigung der Taste "*" und der jeweiligen Taste generiert, die die jeweilige Ziffer bezeichnet. Alternativ kann von der Steuerung MP jeweils eine Zeichenebene (Zeichen die im unteren bzw.im oberen Bereich der Tasten dargestellt sind) für die jeweilige Bedienperson erkennbar vorgegeben sein, so daß sich die Betätigung einer Taste zum Zweck der Aktivierung einer Zeichenebene erübrigt.

Ganz allgemein gilt, daß die Tasten T1...T12 zeilen- und/oder spaltenweise angeordnet sind. Die Zahl der Zeichen bzw. Spalten ist bei bevorzugten Ausführungsformen gleich der Zahl der zu einer Zeichengruppe (ABC,DEF,...) gehörenden Zeichen. Die zu betätige(n) Taste(n) (z.B. T2,T3;T8,T8) sind (ist) in derselben Zeile oder in derselben Spalte angeordnet.

Das erfindungsgemäße Verfahren ist insbesondere für Fernmeldeendgeräte einsetzbar, ganz allgemein bezieht sich die Erfindung jedoch auf Einsatzfälle, in denen mittels Tasten Zeicheninformationen zu bilden, wobei einer Einzeltaste eine Mehrzahl von Zeichen zugeordnet sind.

## Patentansprüche

1. Verfahren zur Generierung von einzelne Zeichen bezeichnende Informationen mittels Tasten (T1...Tn), insbesondere von Fernmeldeendgeräten, wobei den Tasten jeweils eine Gruppe von Zeichen (ABC,DEF,...) zugeordnet ist, wobei einer Steuerung (MP), die die Betätigung der Tasten (T1...Tn) überwacht, ein in der Weise ausgestaltetes Steuerungsprogramm zugeordnet ist, daß in Abhängigkeit der Betätigung der Tasten (T1...Tn) Zeicheninformationen generiert werden,
**dadurch gekennzeichnet,**
daß das der Steuerung (MP) zugeordnete Programm weiterhin in der Weise ausgestaltet ist, daß die Steuerung ausgelöst durch die Betätigung einer ersten Taste (T2), der die ein gewünschtes Zeichen (C) enthaltende Zeichengruppe (ABC) zugeordnet ist, eine erste Information (I1=I(ABC)) bildet, daß die Steuerung (MP) ausgelöst durch die Betätigung einer zweiten Taste (T3), die die Stellung des gewünschten Zeichens (C) innerhalb der Zeichengruppe (ABC) bezeichnet, eine zweite Information (I2=I(3)) bildet und daß die Steuerung (MP) aus der ersten und zweiten Information (I1,I2) eine das gewünschte Zeichen (C) bezeichnende Information (IC) generiert.

2. Anordnung zur Durchführung des Verfahrens nach Anspruch 1, bestehnd aus der Steuerung (MP), aus einem Speicher (RAM) zur Zwischenspeicherung der ersten und zweiten Information (I1,I2) und aus den Tasten (T1...Tn),
**dadurch gekennzeichnet,**
daß das der Steuerung (MP) zugeordnete Steuerungsprogramm das Verfahren definiert.

3. Anordnung nach Anspruch 2,
**dadurch gekennzeichnet,**
daß die Tasten (T1...Tn) zeilen- und/oder spaltenweise angeordnet sind.

4. Anordnung nach Anspruch 3,
**dadurch gekennzeichnet,**
daß die Zahl der Zeilen oder Spalten gleich der Zahl der zu einer Zeichengruppe (ABC,DEF,...) gehörenden Zeichen ist.

5. Anordnung nach Anspruch 3 oder 4,
**dadurch gekennzeichnet,**
daß die zur Bildung eines Zeichens (c) zu betätigende erste und zweite Taste (T2,T3) in derselben Zeile oder in derselben Spalte angeordnet sind.
